# EUROPEAN PATENT SPECIFICATION

(11) **EP 0 756 379 B1**
(45) Date of publication and mention of the grant of the patent: **24.09.2003**
(21) Application number: 95830337.2
(22) Date of filing: 28.07.1995
(51) Int. Cl.: H03K 3/356, G11C 16/06

(54) **Unbalanced latch and fuse circuit including the same**
Asymmetrische Verriegelungsschaltung und diese enthaltende Schmelgsicherungsschatung
Bascule non symétrique et circuit à fusible comportant celle-ci

(43) Date of publication of application: 29.01.1997
(73) Proprietor: STMicroelectronics S.r.l., 20041 Agrate Brianza (Milano) (IT)
(72) Inventor: Pascucci, Luigi, I-20099 Sesto San Giovanni (Milan) (IT); Rolandi, Paolo, I-15059 Volpedo (Alessandria) (IT); Barcella, Antonio, I-24069 Trescore Balneario (Bergamo) (IT); Fontana, Marco, I-20158 Milano (IT)
(74) Representative: Modiano, Guido, Dr.-Ing.

(56) References cited:
- EP-A- 0 650 257

## Description

The present invention relates to an unbalanced latch and to a fully static low-consumption fuse circuit including said latch.

It is known that a static RAM cell or any element of a register that can be implemented in microprocessors requires an appropriate presetting circuit when the device is switched on. Therefore, a static RAM must have a predictable initial memorization state, obtained by pre-memorizing information in the individual cells that constitute the RAM memory.

During manufacture, each cell is preset so as to represent a binary zero or one, so that during operation the state of the cell can switch in order to store binary information.

As already mentioned, in order to pre-memorize binary information in RAM cells it is necessary to have an appropriate presetting circuit which has the drawback that it increases the size of the circuit.

As regards instead nonvolatile memories of the EPROM, EEPROM, and FLASH types, it is well-known to use fuses having the purpose of storing events and of providing programmable configurations. In redundancy circuits, the fuses are used to store the address of the memory line that is replaced with said redundancy circuit.

Static fuses are furthermore used for the configuration of integrated circuits in a nonvolatile manner, in which they can assume switching properties.

Another application can be the programming of delays and jumps in a nonvolatile manner.

A drawback of known fuses is that they are relatively complicated and occupy a considerable portion of silicon on the integrated chip due to the number of components used.

Another drawback is that the fuses are protected against accidental programming, known as "soft-writing", in a complicated manner.

Furthermore, when the fuse is still to be programmed, that is to say, when it is still in the "virgin" state, it has a considerable consumption. This consumption, multiplied by the number of fuses provided in an integrated circuit, is not negligible.

EP-A-0 650 257 discloses an unbalanced latch circuit comprising cross-coupled CMOS inverters. The unbalance is achieved by adjusting the W/L-ratios of the individual FETs. Capacitors are provided to increase the node capacity. This skewing of the sizes of the p-channel transistors and n-channels transistors modifies the logical threshold of a CMOS inverter, see JP57010533 in: Patent Abstracts of Japan or US-A 4 703 201.

According to the textbook P.R. Gray and R.G. Mayer, "Analysis and Design of Analog Integrated Circuits", Third Edition, J. Wiley & Sons, New York. Chichester. Brisbane. Toronto . Singapore, 1993, pages 62 and 63 each FET has an intrinsic threshold voltage which is usually adjusted in processing by implanting additional impurities into the channel region.

Therefore, an aim of the present invention is to provide an unbalanced latch that can be used as an element which can be preset automatically at power-on in a definite state and a fully static low-consumption fuse comprising said latch.

Within the scope of this aim, an object of the present invention is to provide a fully static low-consumption fuse circuit that comprises the unbalanced latch and is simpler than known fuses from a structural point of view.

Another object of the present invention is to provide a fully static low-consumption fuse circuit requiring a smaller number of components than known fuses.

Another object of the present invention is to provide a fully static low-consumption fuse circuit including a single programmable element.

Another object of the present invention is to provide a fully static low-consumption fuse circuit that is protected against accidental programming, known as soft-writing.

Another object of the present invention is to provide a fully static low-consumption fuse circuit capable of performing static reading.

Another object of the present invention is to provide a fully static low-consumption fuse circuit that does not require particular reading circuits.

Another object of the present invention is to provide a fully static low-consumption fuse circuit that is consumption-free after the decision step has occurred.

Another object of the present invention is to provide a fully static low-consumption fuse circuit that avoids any control circuits.

Another object of the present invention is to provide an unbalanced latch, and a fully static low-consumption fuse circuit comprising said latch, that are highly reliable, relatively easy to manufacture, and at competitive costs.

This aim, these objects, and others which will become apparent hereinafter are achieved by a latch circuit as defined in claim 1.

The characteristics and advantages of the invention will become apparent from the description of a preferred but not exclusive embodiment thereof, illustrated only by way of non-limitative example in the accompanying drawings, wherein:
figure 1 is a diagram of the unbalanced latch circuit according to the invention;
figure 2 is a diagram of a first embodiment of the fuse circuit, comprising the unbalanced latch shown in figure 1;
figure 3 is a diagram of a second embodiment of the fuse circuit, including the unbalanced latch shown in figure 1.

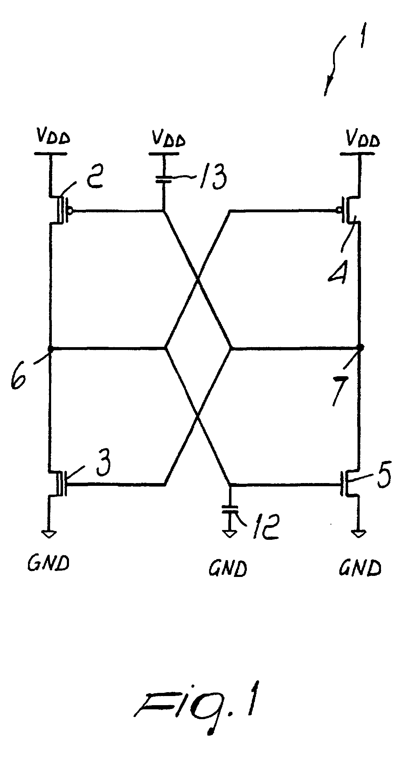

With reference to figure 1, the latch circuit according to the present invention comprises a first transistor 2 of the native P-channel type with a high threshold, on the order of 1.7 V. The drain of the transistor 2 is connected to a supply voltage V_{DD}, whereas the source is connected to the drain of a second transistor 3 of the native N-channel type having a low threshold (on the order of 0.3 V). The source of the second transistor 3 is connected to the ground GND.

The latch circuit 1 furthermore comprises a third transistor 4 of the P-channel LVS (Light Voltage Shift) corrected-threshold type having an average threshold on the order of 0.9 V. The drain terminal of the third transistor 4 is connected to the supply voltage V_{DD}, whereas the source terminal is connected to a fourth transistor 5 of the N-channel LVS type with corrected threshold (typically 0.8 V, higher than the corresponding transistor 3). The source terminal of the fourth transistor 5 is connected to the ground.

A first node 6 is provided on the line that connects the first transistor 2 and the second transistor 3 and is connected to the gates of the third transistor 4 and of the fourth transistor 5. Likewise, on the line that connects the third transistor 4 and the fourth transistor 5 a second node 7 is provided, which is connected to the gates of the first transistor 2 and of the second transistor 3.

In this manner, the first four transistors 2-5 form a classic latch structure, which is intentionally unbalanced due to the different thresholds so that when the supply voltage V_{DD} switches on, the first node 6 tends to reach the ground value GND, whereas the second node 7 tends to reach the value of the supply voltage V_{DD}.

In order to facilitate the operation of the latch structure, a first capacitor 12 is furthermore provided, which is connected between the first node 6 and the ground GND. The first capacitor is advantageously provided in N-type diffusion.

A second capacitor 13 is also provided, advantageously in P-type diffusion, and is interposed between the second node 7 and the supply voltage V_{DD}.

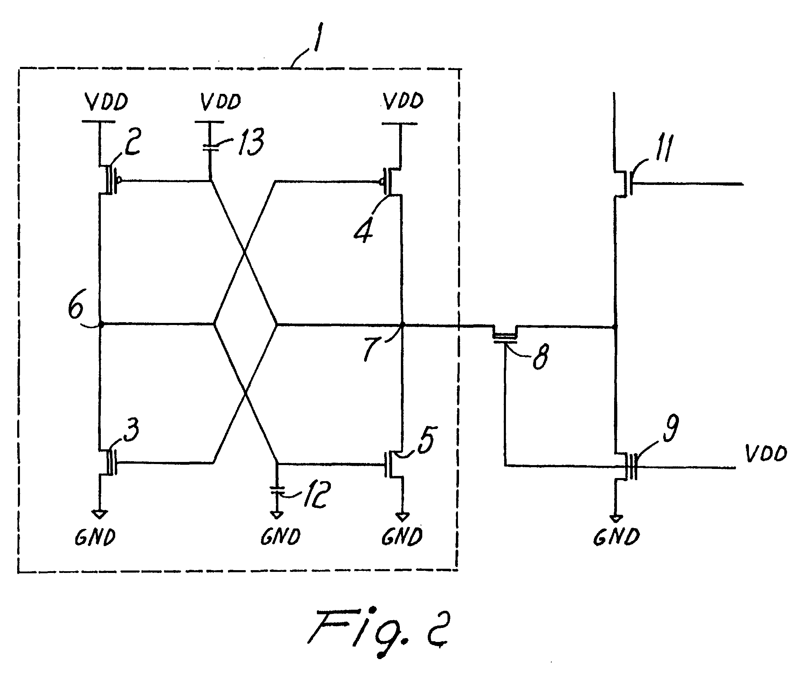

Figure 2 is a diagram of a first embodiment of the above described latch circuit and of a fully static fuse circuit.

A reversing branch is connected to the second node 7 of the latch circuit 1 and is composed of a fifth cascoding transistor 8 of the native N-channel type with a low threshold (on the order of 0.3 V), which is series-connected to the drain terminal of a sixth dual-gate transistor 9 of the nonvolatile N-channel type. Said transistor 8 is not indispensable for the operation of the circuit but has the purpose of adjusting the voltage on the drain of the transistor 9. The sixth transistor 9 has a high threshold (approximately 2.1 V) and acts as a fuse for the circuit, that is to say, it is programmable. The other terminal (the source terminal) of the nonvolatile transistor 9 is connected to the ground.

The gate terminals of the transistors 8 and 9 are connected to the supply voltage V_{DD}. In this manner, when the supply voltage V_{DD} reaches the threshold of the nonvolatile transistor 9, the transistors 8 and 9 are switched on and the second node 7 is connected to the ground GND, whereas the first node 6, owing to the latch structure, is connected to the supply voltage V_{DD}.

The nonvolatile transistor 9 is series-connected to a programming branch constituted by an LVS N-channel transistor 11 with an average threshold on the order of 0.8 V. Said transistor 11, biased appropriately, acts as a current source during programming.

The operation of the latch circuit according to the present invention is as follows.

When the supply voltage is switched on, the first node 6 of the latch circuit 1 tends to remain at the value of the ground GND, since the low-threshold transistor 3 starts to conduct, and the second node 7 tends to reach the supply voltage V_{DD}. In this manner, the latch circuit 1 presets itself, when it switches on, in a definite state by virtue of the imbalance obtained by differentiating the thresholds of the two N-type transistors and the thresholds of the two P-type transistors.

The reason why the thresholds of the P-type transistors must be mutually different, like the thresholds of the N-type transistors, can be more clearly understood by observing figure 1. If the reverse junction current of the P-type transistors 1 and 3 is higher than the reverse current of the N-type transistors 2 and 4, at power-on the two nodes 6 and 7 of the latch circuit 1 are at a voltage the value whereof is equal to the supply voltage. When the value of the voltage reaches the value of the threshold of the native N-type transistor 3, the node 6 discharges to the ground (GND).

If instead the reverse junction current of the P-type transistors 1 and 3 is lower than the reverse junction current of the N-type transistors 2 and 4, then at power-on both nodes 6 and 7 of the latch circuit 1 are connected to the ground (GND); as soon as the power supply reaches a value that is equal to the threshold of the P-type transistor 4, the node 7 becomes charged at the supply voltage V_{DD}.

In both of the above described cases, the latch circuit 1 is in a definite and univocal state.

The operation of the fuse circuit shown in figure 2, which includes the latch of figure 1, is similar for the first power-on step. Then, at approximately 2.1 V, the nonvolatile transistor 9 switches on (whereas the transistor 8 is already on when V_{DD} = 0.5 V) and the operation of the latch circuit 1 is reversed, that is to say, the second node 7 is connected to the ground GND and the first node is connected to the supply voltage V_{DD}, differently from the initial excursion.

The threshold values and the internal resistances of the transistors 4, 8, and 9 and the value of the capacitor 13 (which is connected to the node 7) are chosen so that the voltage at the node 14 connected to the drain of the nonvolatile transistor 9 never exceeds a value of approximately 1 V. In this manner dangerous voltages at the drain of the nonvolatile transistor 9, which might accidentally program said transistor, are avoided.

During programming, a high voltage of approximately 12 V is applied to the gates of the nonvolatile transistor 9 and of the transistor 8. A high voltage of approximately 12 V is also applied to the gate of the programming transistor 11, whereas a voltage on the order of V_{DD} is applied to its drain. The high voltage at the gate of the transistor 11 has the purpose of inducing an intense programming current in the nonvolatile transistor 9. This is necessary only for EPROM and FLASH memories, whereas for EEPROM memories it is sufficient to have a high voltage at the gate of the nonvolatile transistor.

With a high voltage applied to the gate and an intense current present across the drain/source terminals, the floating gate of the transistor 9 is charged and its threshold rises to 6-7 V, that is to say, above the value of V_{DD} that is normally applied to the gate of the transistor 9.

In this manner, once it has been programmed, the transistor 9, by having a voltage V_{DD} applied to its gate, no longer conducts and does not draw the second node towards the ground GND. In this manner, the second node 7 reaches V_{DD}, as defined by the unbalanced latch circuit 1, and the first node 6 reaches the ground GND.

During reading, the voltage at the drain of the programming transistor 11 can have any value, but the voltage on its gate must be equal to 0 V so that it does not conduct current.

During reading, the output values can be taken both from the first node 6 and from the second node 7.

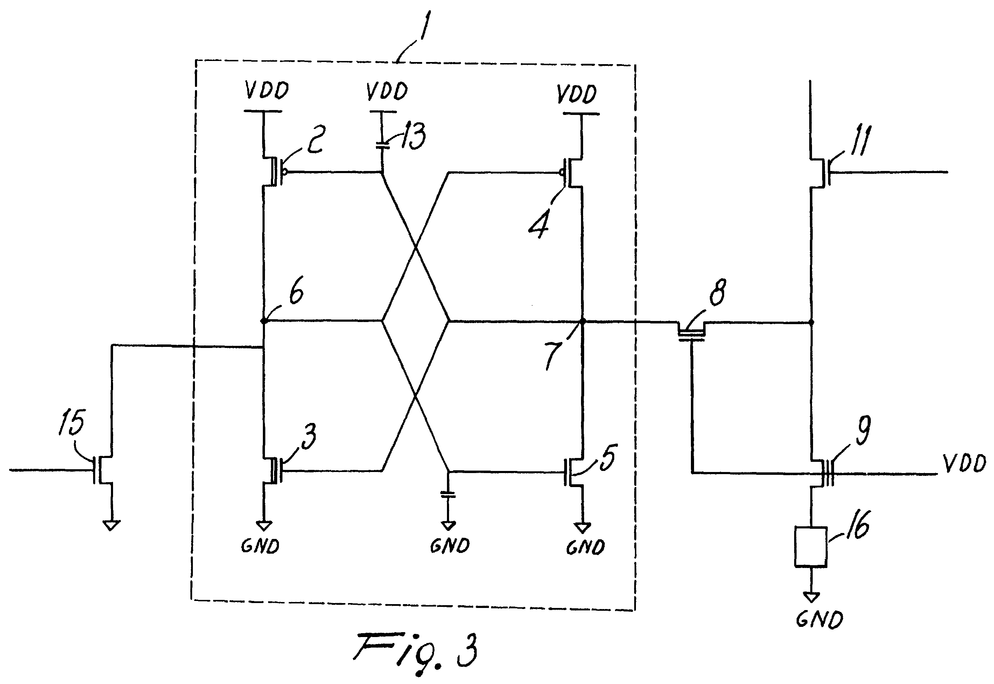

Figure 3 is a diagram of an improved version of the fully static fuse circuit according to the present invention.

The circuit is substantially identical to the circuit of figure 2, with the first difference that it comprises a forced presetting transistor 15 connected between the first node 6 and the ground GND. Said transistor has the purpose of inducing a presetting of the latch circuit 1 (that is to say, to connect the first node to the ground and the second node to V_{DD}) when it is necessary to facilitate presetting at the initial instant of the activation of the circuit and to force said presetting whenever this is desired.

The second difference with respect to the embodiment of figure 1 is that a voltage source 16 is interposed between the nonvolatile transistor 9 and the ground terminal. Said source has the purpose of adjusting the voltage at the source of the nonvolatile transistor 9 during programming and during deletion of the programming of the circuit.

For EPROM memories, the voltage source 16 maintains the voltage at the source of the transistor 9 always at the value of the ground GND.

For FLASH memories, the voltage source 16 maintains the voltage at the source of the transistor 9 at the value of the ground GND during programming and during reading, whereas during deletion it generates a high voltage of approximately 12 V, and a voltage of 0 V is applied to the gate of the transistor 9. In this manner, the floating gate of the transistor 9 discharges and the transistor 9 returns to the virgin state.

For EEPROM memories, the source of the transistor 9 is maintained at ground voltage during reading and floats during programming. Deletion occurs in a manner that is similar to deletion in FLASH memories.

From the above description it is evident that the present invention fully achieves the intended aim and objects.

In particular, an intentionally unbalanced latch circuit is proposed which can act for example as a static RAM cell that can be preset automatically at power-on in a definite state, without requiring a specifically provided external presetting circuit. In order to achieve this, it is sufficient to mutually differentiate the thresholds of the two N-type transistors and the thresholds of the two P-type transistors.

The unbalanced latch circuit furthermore allows to obtain a fully static fuse circuit that is simpler and has a smaller number of components than known circuits. Said circuit furthermore requires only one programmable element, that is to say, the transistor 9.

Furthermore, the nonvolatile transistor 9 is protected against soft-writing in a simple manner by means of the transistor 8.

The circuit furthermore performs static reading, does not require particular read circuits, and avoids any control circuits.

The circuit is also consumption-free after the decision step has occurred.

The invention thus conceived is susceptible of numerous modifications and variations, all of which are within the scope of the inventive concept as defined by the appended claims

Thus, for example, the polarities of the transistors can be reversed and it is possible to use any current source instead of the transistor 11.

Furthermore, even if the transistors shown are of the MOSFET type, they might also be of other kinds.

In practice, the materials employed, as well as the shapes and the dimensions, may be any according to the requirements, without thereby abandoning the scope of the protection of the appended claims.

Where technical features mentioned in any claim are followed by reference signs-, those reference signs have been included for the sole purpose of increasing the intelligibility of the claims and accordingly such reference signs do not have any limiting effect on the interpretation of each element identified by way of example by such reference signs.

## Claims

1. A latch circuit, comprising a first pair of transistors of a first polarity and of a second polarity that are series-connected between a supply voltage and a ground voltage; a second pair of transistors of a first polarity and of a second polarity that are series-connected between said supply voltage and said ground voltage; a first output interposed between the transistors of said first pair and a second output interposed between the transistors of said second pair; the gate terminals of the first pair of transistors being connected to said second output; the gate terminals of said second pair of transistors being connected to said first output; the thresholds of said transistors of said first polarity being mutually different, and the thresholds of said transistors of said second polarity being mutually different, so that said first output reaches ground voltage and said second output reaches the supply voltage, whereby said first pair of transistors comprises a first transistor of said first polarity having a high threshold and a second transistor of said second polarity having a low threshold and in that said second pair of transistors comprises a third transistor of said first polarity, the threshold whereof is different from the threshold of said first transistor, and a fourth transistor of said second polarity having a medium threshold.

2. The circuit according to claim 1, **characterized in that** the drain terminal of said first transistor is connected to said supply voltage and the source terminal of said second transistor is connected to said ground voltage.

3. The circuit according to claim 1, **characterized in that** the drain terminal of said third transistor is connected to said supply voltage and the source terminal of said fourth transistor is connected to said ground voltage.

4. The circuit according to claim 1, **characterized in that** it comprises a first capacitor that is connected between said first output and said ground voltage, said first capacitor being of the N-type diffusion.

5. The circuit according to claim 1, **characterized in that** it comprises a second capacitor that is connected between said second output and said ground voltage, said second capacitor being of the P-type diffusion.

## Patentansprüche

1. Eine Verriegelungsschaltung, mit einem ersten Paar von Transistoren einer ersten Polarität und einer zweiten Polarität, die in Reihe zwischen einer Versorgungsspannung und einer Massespannung geschaltet sind, einem zweiten Paar von Transistoren einer ersten Polarität und einer zweiten Polarität, die in Reihe zwischen der Versorgungsspannung und der Massespannung geschaltet sind; einem zwischen den Transistoren des ersten Paars geschalteten ersten Ausgang und einem zwischen den Transistoren des zweiten Paars geschalteten zweiten Ausgang; wobei die Gate-Anschlüsse des ersten Paars der Transistoren am zweiten Ausgang angeschlossen sind; wobei die Gate-Anschlüsse des zweiten Paares der Transistoren am ersten Ausgang angeschlossen sind; wobei die Schwellwerte der Transistoren der ersten Polarität zueinander unterschiedlich und die Schwellwerte der Transistoren der zweiten Polarität zueinander unterschiedlich sind, so dass der erste Ausgang die Massespannung und der zweite Ausgang die Versorgungsspannung erreicht, wodurch das erste Paar der Transistoren einen ersten Transistor der ersten Polarität mit einem hohen Schwellwert und einen zweiten Transistor der zweiten Polarität mit einem geringen Schwellwert und das zweite Paar von Transistoren einen dritten Transistor der ersten Polarität, dessen Schwellwert vom Schwellwert des ersten Transistors unterschiedlich ist, und einen vierten Transistor der zweiten Polarität mit einem mittleren Schwellwert aufweist.

2. Die Schaltung nach Anspruch 1,
**dadurch gekennzeichnet, dass** der Drain-Anschluss des ersten Transistors mit der Spannungsversorgung und der Source-Anschluss des zweiten Transistors mit der Massespannung verbunden ist.

3. Die Schaltung nach Anspruch 1,
**dadurch gekennzeichnet, dass** der Drain-Anschluss des dritten Transistors mit der Versorgungsspannung und der Source-Anschluss des vierten Transistors mit der Massespannung verbunden ist.

4. Die Schaltung nach Anspruch 1,
**dadurch gekennzeichnet, dass** sie einen ersten Kondensator aufweist, der zwischen dem ersten Ausgang und der Massespannung geschaltet ist, wobei der erste Kondensator von N-leitender Diffusion ist.

5. Die Schaltung nach Anspruch 1,
**dadurch gekennzeichnet, dass** sie einen zweiten Kondensator aufweist, der zwischen dem zweiten Ausgang und der Massespannung geschaltet ist, wobei der zweite Kondensator von P-leitender Diffusion ist.

## Revendications

1. Circuit de bascule comprenant une première paire de transistors d'une première polarité et d'une seconde polarité qui sont connectés en série entre une tension d'alimentation et une tension de masse ; une seconde paire de transistors d'une première polarité et d'une seconde polarité qui sont connectés en série entre la tension d'alimentation et la tension de masse ; une première sortie interposée entre les transistors de la première paire et une seconde sortie interposée entre les transistors de la seconde paire ; les bornes de grille de la première paire de transistors étant connectées à la seconde sortie ; les bornes de grille de la seconde paire de transistors étant connectées à la seconde sortie ; les bornes de grille de la seconde paire de transistors étant connectées à la première sortie ; les seuils des transistors de la première polarité étant mutuellement différents et les seuils des transistors de la seconde polarité étant mutuellement différents, de sorte que la première sortie atteint la tension de masse et la seconde sortie atteint la tension d'alimentation, dans lequel la première paire de transistors comprend un premier transistor de la première polarité ayant un seuil haut et un second transistor de la seconde polarité ayant un seuil bas, et dans lequel la seconde paire de transistors comprend un troisième transistor de la première polarité dont le seuil est différent du seuil du premier transistor et un quatrième transistor de la seconde polarité ayant un seuil médian.

2. Circuit selon la revendication 1, **caractérisé en ce que** la borne de drain du premier transistor est connectée à la tension d'alimentation et la borne de source du second transistor est connectée à la tension de masse.

3. Circuit selon la revendication 1, **caractérisé en ce que** la borne de drain du troisième transistor est connectée à la tension d'alimentation et la borne de source du quatrième transistor est connectée à la tension de masse.

4. Circuit selon la revendication 1, **caractérisé en ce qu'**il comprend un premier condensateur connecté entre la première sortie et la tension de masse, le premier condensateur étant à diffusion de type N.

5. Circuit selon la revendication 1, **caractérisé en ce qu'**il comprend un second condensateur connecté entre la seconde sortie et la tension de masse, le second condensateur étant à diffusion de type P.
